# EUROPEAN PATENT APPLICATION

(11) **EP 4 682 948 A1**
(43) Date of publication of application: **21.01.2026**
(21) Application number: 23945738.5
(22) Date of filing: 28.12.2023
(51) Int. Cl.: H01L 21/764, H10B 12/00

(54) **PREPARATION METHOD FOR SEMICONDUCTOR STRUCTURE AND SEMICONDUCTOR STRUCTURE**

(30) Priority: 14.07.2023 CN 202310870269
(71) Applicant: Changxin Memory Technologies, Inc., Hefei, Anhui 230601 (CN)
(72) Inventor: LI, Haoran, Hefei, Anhui 230601 (CN); YANG, Zhi, Hefei, Anhui 230601 (CN)
(74) Representative: Gulde & Partner
(86) International application number: PCT/CN2023/142873
(87) International publication number: WO 2025/015860

(57) **Abstract**

A fabrication method for a semiconductor structure and a semiconductor structure are provided. The fabrication method for a semiconductor structure includes the steps as follows. A substrate is provided; multiple landing pad structures arranged at intervals are formed on an array region of the substrate, first conductive layers are formed on a peripheral region of the substrate, and a sacrificial spacer layer is formed on at least one side of each of the landing pad structures, where a gap exists between two adjacent ones of the landing pad structures; a dielectric layer is formed on the landing pad structures and the first conductive layers, where the dielectric layer covers an opening of the gap; the dielectric layer in the array region is removed and the gap is exposed; and the sacrificial spacer layer is removed to form air gaps.

## Description

### CROSS-REFERENCE TO RELATED APPLICATIONS

The present disclosure is based on and claims priority to Chinese Patent Application No. 202310870269.4, filed on July 14, 2023 and entitled "FABRICATION METHOD FOR SEMICONDUCTOR STRUCTURE AND SEMICONDUCTOR STRUCTURE". The above-referenced application is incorporated herein by reference in its entirety.

### TECHNICAL FIELD

The present disclosure relates to the field of semiconductor technologies, and in particular, to a fabrication method for a semiconductor structure and a semiconductor structure.

### BACKGROUND

A reduction of the bit line parasitic capacitance (CBL) in an advanced dynamic random access memory (DRAM, Dynamic Random Access Memory) process is always a difficulty and a focus in technology development. An air gap (Air gap) makes a significant improvement in reducing the parasitic capacitance between a bit line (BL) and a node contact (NC).

However, in a related process, a process cost of forming an air gap is relatively high, and an effect of forming the air gap is relatively poor.

### SUMMARY

Based on this, embodiments of the present disclosure provide a fabrication method for a semiconductor structure and a semiconductor structure.

According to a first aspect of the embodiments of the present disclosure, a fabrication method for a semiconductor structure is provided, and includes the steps as follows.

A substrate is provided, where the substrate includes an array region and a peripheral region;
multiple landing pad structures arranged at intervals are formed on the array region, first conductive layers are formed on the peripheral region, and a sacrificial spacer layer is formed on at least one side of each of the landing pad structures, where a gap exists between two adjacent ones of the landing pad structures;
a dielectric layer is formed on the landing pad structures and the first conductive layers, where the dielectric layer covers an opening of the gap;
second conductive layers are formed on the dielectric layer in the peripheral region;
the dielectric layer in the array region is removed and the gap is exposed; and
the sacrificial spacer layer is removed to form air gaps.

In some embodiments, the material of the dielectric layer includes at least one of the following: undoped silicon glass, phosphorus-doped silicon glass, boron-phosphorus-doped silicon glass, undoped spin-on-glass, boron-doped spin-on-glass, phosphorus-doped spin-on-glass, undoped tetraethyl orthosilicate, phosphorus-doped tetraethyl orthosilicate, or boron-doped tetraethyl orthosilicate.

In some embodiments, the method further includes the steps as follows.

A first insulating layer covering the surface of each of the landing pad structures, the top surface of the sacrificial spacer layer, and the first conductive layers is formed before the dielectric layer is formed, where the thickness of the first insulating layer is less than one half of the minimum inner diameter of the gap;
the dielectric layer is formed on the first insulating layer, where the bottom surface of the dielectric layer is flush with or higher than the top surface of each of the landing pad structures; and
at least a part of the first insulating layer is removed before the sacrificial spacer layer is removed, to expose the top surface of the sacrificial spacer layer.

In some embodiments, that at least a part of the first insulating layer is removed to expose the top surface of the sacrificial spacer layer includes the steps as follows.

The first insulating layer covering the top surface of the sacrificial spacer layer and the top surface of each of the landing pad structures is removed by adopting a dry etching process, to expose the top surface of the sacrificial spacer layer; or the entire first insulating layer located in the array region is removed by adopting a wet etching process, to expose the top surface of the sacrificial spacer layer.

In some embodiments, that the sacrificial spacer layer is removed to form air gaps includes the step as follows.

The sacrificial spacer layer is removed by adopting the wet etching process to form the air gaps.

In some embodiments, the method further includes the step as follows.

A second insulating layer is formed in the gap between the two adjacent ones of the landing pad structures after the air gaps are formed, where the second insulating layer covers an opening of each of the air gaps.

In some embodiments, before the multiple landing pad structures arranged at intervals are formed on the array region, the method further includes the steps as follows.

Multiple bit line structures are formed on the array region, where the bit line structures extend in a first direction, and the sacrificial spacer layer is formed on a sidewall of each of the bit line structures;
a contact hole and an isolation structure alternately arranged in the first direction are formed between the bit line structures, where the contact hole exposes the substrate, and the first direction is parallel to the surface of the substrate; and
a storage node contact plug is formed in the contact hole, where each of the landing pad structures is located on the storage node contact plug.

In some embodiments, that multiple landing pad structures arranged at intervals are formed on the array region includes the steps as follows.

A landing pad material layer is formed on the storage node contact plug, where the top surface of the landing pad material layer is higher than the top surface of each of the bit line structures; and
a part of the landing pad material layer and parts of the bit line structures are etched back to form the landing pad structures and the gap located on one side of each of the landing pad structures, where the projection of each of the landing pad structures on the substrate partly overlaps the projection of each of the bit line structures on the substrate.

In some embodiments, the method further includes the steps as follows.

A trench running through the dielectric layer in the peripheral region is formed before the second conductive layers are formed, where the trench exposes the surface of each of the first conductive layers; and
a conductive layer contact plug is formed in the trench, where the first conductive layers are electrically connected to the second conductive layers through the conductive layer contact plug.

According to a second aspect of the embodiments of the present disclosure, a semiconductor structure is provided, including:
a substrate, including an array region and a peripheral region;
bit line structures located on the array region, where the bit line structures extend in a first direction;
landing pad structures arranged at intervals in the first direction and located between the bit line structures, where the first direction is parallel to the surface of the substrate;
air gaps, located among the landing pad structures and the bit line structures;
first conductive layers, located on the peripheral region;
a first insulating layer, conformally covering the first conductive layers;
a dielectric layer, located on the first insulating layer; and
second conductive layers, located on the dielectric layer.

In some embodiments, the material of the dielectric layer includes at least one of the following:
undoped silicon glass, phosphorus-doped silicon glass, boron-phosphorus-doped silicon glass, undoped spin-on-glass, boron-doped spin-on-glass, phosphorus-doped spin-on-glass, undoped tetraethyl orthosilicate, phosphorus-doped tetraethyl orthosilicate, or boron-doped tetraethyl orthosilicate.

In some embodiments, the size of the first insulating layer in a direction parallel to the thickness direction of the substrate is smaller than the size of the dielectric layer in the direction parallel to the thickness direction of the substrate.

In some embodiments, the air gaps are located on two sides of each of the bit line structures, and an extension direction of each of the air gaps is the same as an extension direction of each of the bit line structures.

In some embodiments, the semiconductor structure further includes:
a storage node contact plug, where each of the landing pad structures is located on the storage node contact plug; and
a bit line contact plug, where each of the bit line structures is located on the bit line contact plug; and
the air gaps are at least partially located between the storage node contact plug and each of the bit line structures.

In some embodiments, an isolation groove is formed in the dielectric layer, the bottom surface of the isolation groove is lower than the bottom surface of each of the second conductive layers, and the projection of the isolation groove on the substrate is located between the projections of the second conductive layers on the substrate.

In the embodiments of the present disclosure, the dielectric layer is formed on the landing pad structures and the first conductive layers, and the dielectric layer covers the opening of the gap, but does not fill the gap. In this way, after the second conductive layers are formed in the peripheral region, when the dielectric layer in the array region is removed, because the dielectric layer does not fill the gap, there is no residue of the dielectric layer removed in the gap, and there is no case in which formation of the air gaps is affected by the residue. In addition, in the embodiments of the present disclosure, after the dielectric layer is removed, the sacrificial spacer layer can be simply and conveniently exposed, to remove the sacrificial spacer layer, and form the air gaps. Therefore, the solution provided in the embodiments of the present disclosure has simple processes, low costs, and air gaps formed with a relatively good effect.

### BRIEF DESCRIPTION OF DRAWINGS

To describe the technical solutions in the embodiments of the present disclosure or the conventional technologies more clearly, the following briefly describes the accompanying drawings required for the embodiments. Clearly, the accompanying drawings in the following description show merely some embodiments of the present disclosure, and a person of ordinary skill in the art may still derive other accompanying drawings from these accompanying drawings without creative efforts.
FIG. 1 is a flowchart of a fabrication method for a semiconductor structure according to an embodiment of the present disclosure;
FIG. 2a is a schematic structural diagram 1 of a semiconductor structure in a fabrication procedure according to an embodiment of the present disclosure;
FIG. 2b is a schematic structural diagram 2 of a semiconductor structure in a fabrication procedure according to an embodiment of the present disclosure;
FIG. 2c is a schematic structural diagram 3 of a semiconductor structure in a fabrication procedure according to an embodiment of the present disclosure;
FIG. 2d is a schematic structural diagram 4 of a semiconductor structure in a fabrication procedure according to an embodiment of the present disclosure;
FIG. 2e is a schematic structural diagram 5 of a semiconductor structure in a fabrication procedure according to an embodiment of the present disclosure;
FIG. 2f is a schematic structural diagram 6 of a semiconductor structure in a fabrication procedure according to an embodiment of the present disclosure;
FIG. 2g is a schematic structural diagram 7 of a semiconductor structure in a fabrication procedure according to an embodiment of the present disclosure;
FIG. 2h is a schematic structural diagram 8 of a semiconductor structure in a fabrication procedure according to an embodiment of the present disclosure;
FIG. 2i is a schematic structural diagram 9 of a semiconductor structure in a fabrication procedure according to an embodiment of the present disclosure;
FIG. 3a is a schematic structural diagram 1 of another semiconductor structure in a fabrication procedure according to an embodiment of the present disclosure;
FIG. 3b is a schematic structural diagram 2 of another semiconductor structure in a fabrication procedure according to an embodiment of the present disclosure; and
FIG. 4 is a schematic structural diagram of a semiconductor structure according to a semiconductor embodiment.

Descriptions of reference numerals:
substrate, 10; array region, 11; peripheral region, 12; gate structure, 13; gate insulating layer, 131; first gate conductive layer, 132; second gate conductive layer, 133; third gate conductive layer, 134; cover layer, 135; gate spacer layer, 14; isolation sidewall, 101; isolation structure, 15;
landing pad structure, 20; landing pad material layer, 200; capacitor structure, 21;
first conductive layer, 31; first conductive material layer, 310; second conductive layer, 32; conductive layer contact plug, 33; trench, T;
sacrificial spacer layer, 41; air gap, 42;
gap, 50;
dielectric layer, 60; isolation groove, 601;
first insulating layer, 71; second insulating layer, 72;
bit line structure, 80; first bit line conductive layer, 81; second bit line conductive layer, 82; bit line cover layer, 83;
contact hole, 901; storage node contact plug, 91; bit line contact plug, 92.

### DESCRIPTION OF EMBODIMENTS

Example implementations disclosed by the present disclosure are described in more detail below with reference to the accompanying drawings. Although the example implementations of the present disclosure are shown in the accompanying drawings, it should be understood that the present disclosure may be implemented in various forms without being limited by the specific implementations described herein. Instead, these implementations are provided to implement a more thorough understanding of the present disclosure and to fully convey the scope disclosed by the present disclosure to a person skilled in the art.

In the following descriptions, a large quantity of specific details are given to provide a more thorough understanding of the present disclosure. However, it is clear to a person skilled in the art that the present disclosure may be implemented without one or more of these details. In other examples, some technical features well-known in the art are not described to avoid confusion with the present disclosure. That is, not all features of actual embodiments are described herein, and well-known functions and structures are not described in detail.

In the accompanying drawings, for clarity, sizes of a layer, a region, and an element, and relative sizes thereof may be exaggerated. The same reference numerals indicate the same elements.

It should be understood that, an element or a layer may be directly on, adjacent to, connected to, or coupled to another element or layer or there may be an intermediate element or layer when the element or the layer is referred to as "on", "adjacent to", "connected to", or "coupled to" the another element or layer. Instead, there is no intermediate element or layer when an element is referred to as "directly on", "directly adjacent to", "directly connected to", or "directly coupled to" another element or layer. It should be understood that, although the terms "first", "second", "third", and the like may be utilized to describe various elements, components, regions, layers, and/or portions, these elements, components, regions, layers, and/or portions shall not be limited by these terms. These terms are merely utilized to distinguish one element, component, region, layer, or portion from another element, component, region, layer, or portion. Therefore, a first element, component, region, layer, or portion discussed below may be represented as a second element, component, region, layer, or portion without departing from the teachings of the present disclosure. However, when the second element, component, region, layer, or portion is discussed, it does not indicate that there is the first element, component, region, layer, or portion necessarily in the present disclosure.

Spatial relationship terms, e.g., "under", "below", "underlying", "beneath", "over", and "above" may be utilized herein for convenience of description, to describe the relationship between one element or feature and another element or feature shown in the figures. It should be understood that in addition to the orientations shown in the figures, the spatial relationship terms are further intended to include different orientations of components in use and operation. An element or a feature described as "below another element" is oriented to be "above" the another element or feature, for example, if the components in the accompanying drawings are flipped. Therefore, the example terms "below" and "beneath" may include orientations of being above and being below. The component may be otherwise oriented (rotated by 90 degrees or oriented in another manner), and the spatial descriptors utilized herein are interpreted accordingly.

The terms utilized herein are intended merely to describe specific embodiments and are not construed as a limitation on the present disclosure. As utilized herein, "a", "one", and "the" for describing singular forms are also intended to describe plural forms unless otherwise clearly indicated in the context. It should be further understood that the terms "constitute" and/or "include" are utilized in the specification to determine the presence of the features, integers, steps, operations, elements, and/or components, but not rule out the presence or addition of one or more other features, integers, steps, operations, elements, components, and/or groups. As utilized herein, the term "and/or" includes any and all combinations of the related items listed.

For a thorough understanding of the present disclosure, detailed steps and detailed structures are provided in the following descriptions to illustrate the technical solutions of the present disclosure. Preferred embodiments of the present disclosure are described in detail as follows. However, the present disclosure may have other implementations in addition to these detailed descriptions.

A method for forming an air gap in a related technology includes the step as follows. After a fabrication procedure of forming a metal layer in a peripheral region, and before a fabrication procedure of forming a capacitor structure, an extra fabrication procedure of forming the air gap located on a sidewall of a bit line in an array region is added. However, multiple film layer deposition and etching removal processes are required in this solution. In addition, in the fabrication procedure of this solution, there is a risk of residual photoresist (PR) between landing pad (Landing Pad) structures. The residual photoresist affects the formation of the air gap and even causes the failure of the formation of the air gap.

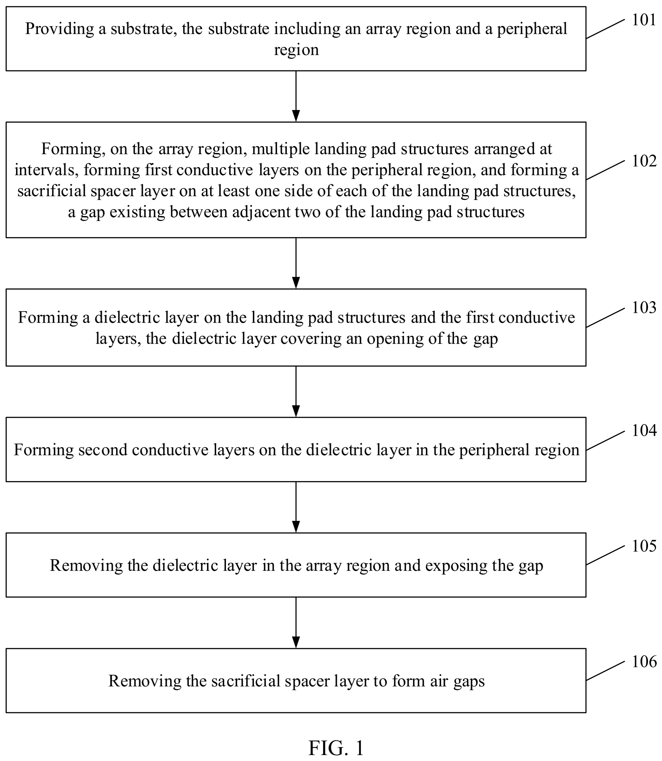

An embodiment of the present disclosure provides a fabrication method for a semiconductor structure. For details, refer to FIG. 1. As shown in FIG. 1, the method includes the following steps:

In the step of 101, a substrate is provided, where the substrate includes an array region and a peripheral region.

In the step of 102, multiple landing pad structures arranged at intervals are formed on the array region, first conductive layers are formed on the peripheral region, and a sacrificial spacer layer is formed on at least one side of each of the landing pad structures, where a gap exists between two adjacent ones of the landing pad structures.

In the step of 103, a dielectric layer is formed on the landing pad structures and the first conductive layers, where the dielectric layer covers an opening of the gap.

In the step of 104, second conductive layers are formed on the dielectric layer in the peripheral region.

In the step of 105, the dielectric layer in the array region is removed, and the gap is exposed.

In the step of 106, the sacrificial spacer layer is removed to form air gaps.

The following further describes in detail the fabrication method for a semiconductor structure provided in the embodiments of the present disclosure with reference to specific embodiments.

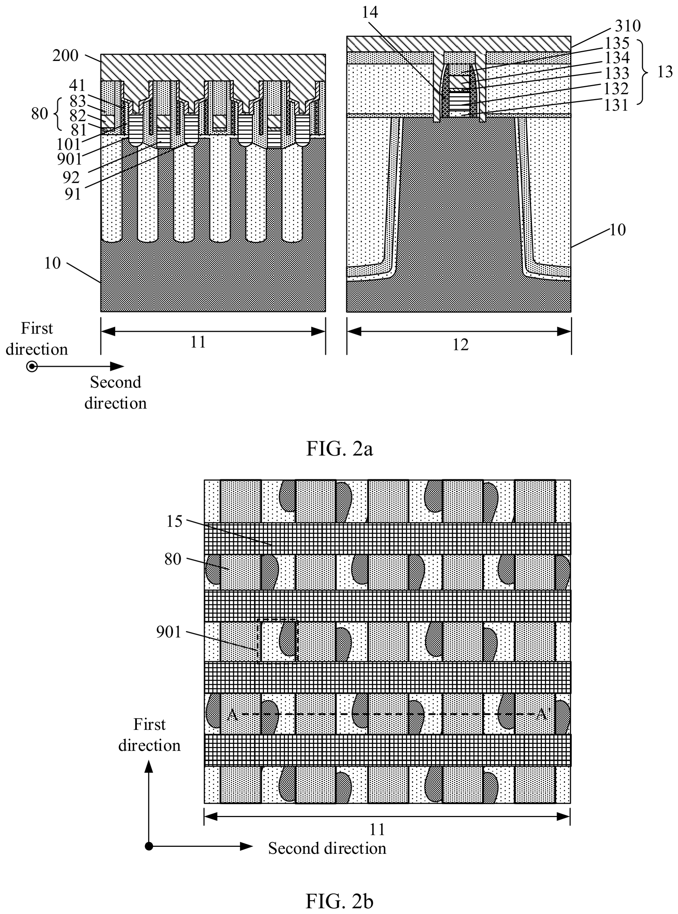

FIG. 2a to FIG. 3b are schematic structural diagrams of a semiconductor structure in a fabrication procedure according to an embodiment of the present disclosure. FIG. 2b is a schematic top view of an array region in FIG. 2a. A schematic structural diagram of the array region in FIG. 2a is a schematic cross-sectional structural diagram taken along a line AA' in FIG. 2b.

First, referring to FIG. 2a, the step of 101 is performed, that is, a substrate 10 is provided, where the substrate 10 includes an array region 11 and a peripheral region 12.

In an embodiment, the substrate 10 may be a silicon substrate, a germanium substrate, a silicon germanium substrate, a silicon carbide substrate, a silicon on insulator (Silicon On Insulator, SOI) substrate, a germanium on insulator (Germanium On Insulator, GOI) substrate, or the like, may be a substrate including another element semiconductor or a compound semiconductor, e.g., a glass substrate or a III-V group compound substrate (e.g., a gallium nitride substrate or a gallium arsenide substrate), may be a stacked structure, e.g., an Si/SiGe structure, or may be another epitaxial structure, e.g., a silicon germanium on insulator (SGOI) structure.

The substrate 10 includes an active region and an isolation region (not marked in FIG. 2a), and the isolation region limits the substrate 10 to multiple discrete active regions.

A gate structure 13 is formed on the substrate 10 in the peripheral region 12. The gate structure 13 includes a gate insulating layer 131, a first gate conductive layer 132, a second gate conductive layer 133, a third gate conductive layer 134, and a cover layer 135 that are stacked sequentially from bottom to top. The material of the gate insulating layer 131 includes but is not limited to an oxide. The material of the first gate conductive layer 132 includes but is not limited to polysilicon. The material of the second gate conductive layer 133 includes but is not limited to titanium nitride. The material of the third gate conductive layer 134 includes but is not limited to metal tungsten. The material of the cover layer 135 includes but is not limited to an oxide, a nitride, a metal oxide, a nitrogen oxide, and the like.

In an embodiment, the semiconductor structure further includes a gate spacer layer 14, and the gate spacer layer 14 covers a sidewall of the gate structure 13.

The active region of the substrate 10 in the peripheral region 12 includes a first source drain region and a second source drain region (not marked in FIG. 2a) located on two opposite sides of the gate structure 13.

The semiconductor structure further includes a connection column (not marked in FIG. 2a), and the connection column electrically connects the first conductive layers to the first source drain region and the second source drain region.

Next, referring to FIG. 2a to FIG. 2c, the step of 102 is performed, that is, multiple landing pad structures 20 arranged at intervals are formed on the array region 11, first conductive layers 31 are formed on the peripheral region 12, and a sacrificial spacer layer 41 is formed on at least one side of each of the landing pad structures 20, where a gap 50 exists between two adjacent ones of the landing pad structures 20.

Specifically, before the multiple landing pad structures 20 arranged at intervals are formed on the array region 11, the foregoing method further includes the steps as follows.

Multiple bit line structures 80 are formed on the array region 11, where the bit line structures 80 extend in a first direction, and the sacrificial spacer layer 41 and an isolation sidewall 101 are formed on a sidewall of each of the bit line structures 80;
a contact hole 901 and an isolation structure 15 alternately arranged in the first direction are formed between the bit line structures 80 (refer to FIG. 2b), where the contact hole 901 exposes the substrate 10, and the first direction intersects a second direction and both are parallel to the surface of the substrate 10; and
a storage node contact plug 91 is formed in the contact hole 901, where each of the landing pad structures 20 is located on the storage node contact plug 91.

The first direction is an extension direction of the bit line structures 80, and the second direction is an arrangement direction of the bit line structures 80.

In some embodiments, the first direction is perpendicular to the second direction.

In some other embodiments, an included angle between the first direction and the second direction is less than 90°.

In an actual operation, the bit line structures 80 and the storage node contact plug 91 may be formed by any one of a physical vapor deposition (Physical Vapor Deposition, PVD) process, a chemical vapor deposition (Chemical Vapor Deposition, CVD) process, and an atomic layer deposition (Atomic Layer Deposition, ALD) process, or a combination thereof. The physical vapor deposition process is a technology of gasifying a material source and a solid or liquid surface into a gaseous atom, a molecule, or ionizing a part of same into ions by adopting a physical method under a vacuum condition, and depositing a thin film with a special function on the substrate surface by adopting a low-pressure gas (or plasma) procedure. The chemical vapor deposition process is mainly a method of utilizing one or more gaseous compounds or monomers including thin film elements to perform a chemical reaction on the surface of the substrate 10 to form a thin film. The atomic layer deposition process is a method in which a substance can be plated layer by layer on the surface of a base in the form of a single atomic film.

In some embodiments, after the bit line structures 80 are formed, the isolation structure 15 extending in the second direction may be formed first. The bit line structures 80 and the isolation structure 15 enclose an initial contact hole. The bit line structures 80 and the isolation structure 15 serve as masks, and etching is performed along the initial contact hole to remove a part of the substrate 10 to form the contact hole 901. The storage node contact plug 91 is filled in the contact hole 901. In some other embodiments, after the bit line structures 80 are formed, the initial storage node contact material is filled between the bit line structures 80. The initial storage node contact material is etched to form multiple storage node contact plugs 91 arranged in an array in the first direction and the second direction, and interval space located between the multiple storage node contact plugs 91, to form the isolation structure 15 in the interval space.

It should be noted that to more clearly show the position relationship among the bit line structures 80, the contact hole 901, and the isolation structure 15, structures such as the storage node contact plug 91, the landing pad material layer 200, the sacrificial spacer layer 41, and the isolation sidewall 101 in FIG. 2a are omitted in FIG. 2b.

Each of the bit line structures 80 includes a first bit line conductive layer 81, a second bit line conductive layer 82, and a bit line cover layer 83 that are sequentially stacked. The material of the first bit line conductive layer 81 includes but is not limited to titanium nitride, tantalum nitride (TaN), metal silicide, metal alloy, or any combination thereof. The material of the second bit line conductive layer 82 includes but is not limited to tungsten (W), copper (Cu), titanium (Ti), or tantalum (Ta). The material of the bit line cover layer 83 includes but is not limited to silicon nitride. In a specific embodiment, the first bit line conductive layer 81 is a titanium nitride layer, and the second bit line conductive layer 82 is a metal tungsten layer.

In an embodiment, the foregoing method further includes the steps as follows. A bit line contact plug 92 is formed before the bit line structures 80 are formed, where each of the bit line structures 80 is located on the bit line contact plug 92.

The bit line structures 80 are electrically connected to the active region through the bit line contact plug 92. The material of the bit line contact plug 92 includes but is not limited to polysilicon.

In an actual operation, the bit line contact plug 92 may be formed by any one of the physical vapor deposition process, the chemical vapor deposition process, and the atomic layer deposition process, or a combination thereof.

In an embodiment, that the multiple landing pad structures 20 arranged at intervals are formed on the array region 11 includes the steps as follows.

Referring to FIG. 2a, a landing pad material layer 200 is formed on the storage node contact plug 91, where the top surface of the landing pad material layer 200 is higher than the top surface of each of the bit line structures 80.

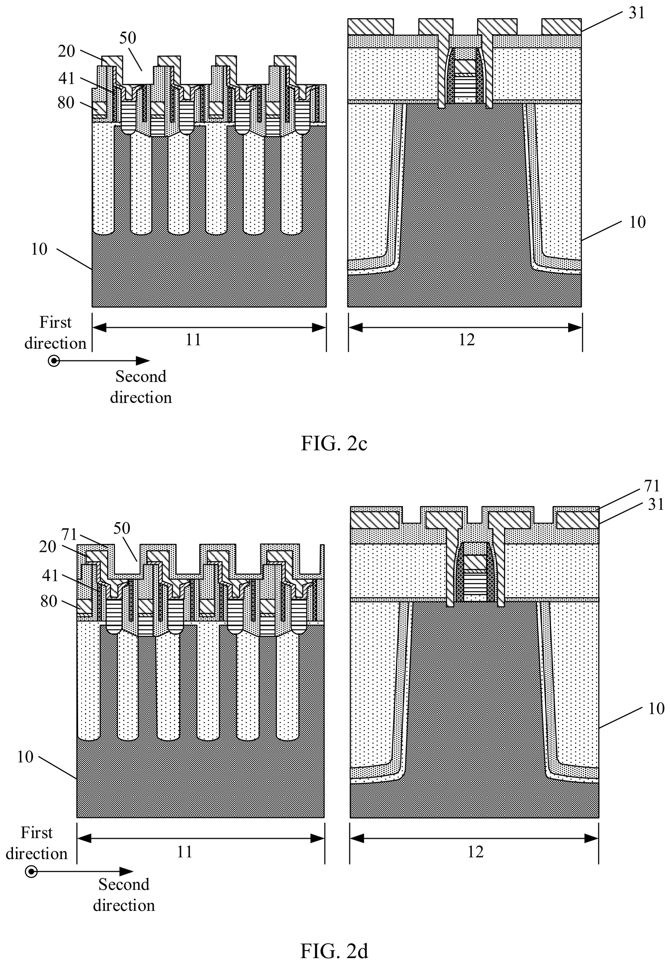

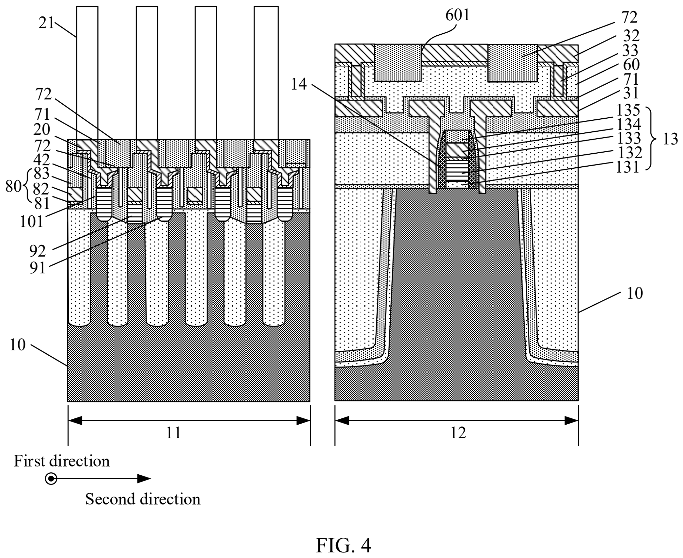

Referring to FIG. 2c, a part of the landing pad material layer 200 and parts of the bit line structures 80 are etched back to form the landing pad structures 20 and the gap 50 located on one side of each of the landing pad structures 20, where a projection of each of the landing pad structures 20 on the substrate 10 partly overlaps a projection of each of the bit line structures 80 on the substrate 10. The projection of the storage node contact plug 91 on the substrate 10 may be arranged in a quadrilateral manner. The projection of the top surface of each of the landing pad structures 20 on the substrate 10 may be arranged in a hexagonal manner. The arrangement layout of the landing pad structures 20 is changed by forming the gap 50, thereby improving the degree of integration of capacitor structures 21 (refer to FIG. 4) subsequently formed on the landing pad structures 20.

Referring to FIG. 2c, a part of the landing pad structures 20 covers the surface of the bit line structures 80. Therefore, the projections of the landing pad structures 20 and the bit line structures 80 on the substrate 10 partially overlap.

Referring to FIG. 2a, while the landing pad material layer 200 is formed, a first conductive material layer 310 is formed on the substrate 10 in the peripheral region 12.

In an actual operation, the landing pad material layer 200 and the first conductive material layer 310 may be formed by any one of the physical vapor deposition process, the chemical vapor deposition process, and the atomic layer deposition process, or a combination thereof.

Referring to FIG. 2c, while a part of the landing pad material layer 200 is etched back to form the landing pad structures 20, a part of the first conductive material layer 310 is removed through etching to form the first conductive layers 31.

The material of each of the first conductive layers 31 includes but is not limited to tungsten (W), copper (Cu), titanium (Ti), tantalum (Ta), titanium nitride (TiN), tantalum nitride (TaN), a metal silicide, a metal alloy, or any combination thereof.

Next, referring to FIG. 2d, the foregoing method further includes the step as follows. A first insulating layer 71 covering the surface of each of the landing pad structures 20, the top surface of the sacrificial spacer layer 41, and the first conductive layers 31 is formed before a dielectric layer 60 is formed, where the thickness of the first insulating layer 71 is less than one half of the minimum inner diameter of the gap 50.

Before the dielectric layer 60 is formed, the first insulating layer 71 is formed first, to protect the landing pad structures 20 from being damaged in a subsequent process. In addition, the thickness of the first insulating layer 71 is less than one half of the minimum inner diameter of the gap 50, which indicates that the first insulating layer 71 does not completely fill the gap 50, but can reduce an opening of the gap 50, so that the dielectric layer 60 in the array region 11 does not fill the gap 50. In addition, the width of the first insulating layer 71 is relatively small, which is relatively easy to subsequently remove, thereby simplifying a process step.

In an actual operation, the first insulating layer 71 may be formed by any one of the physical vapor deposition process, the chemical vapor deposition process, and the atomic layer deposition process, or a combination thereof.

The material of the first insulating layer 71 includes but is not limited to silicon nitride, and a hydrocarbon or a polymer that can be thermally decomposed.

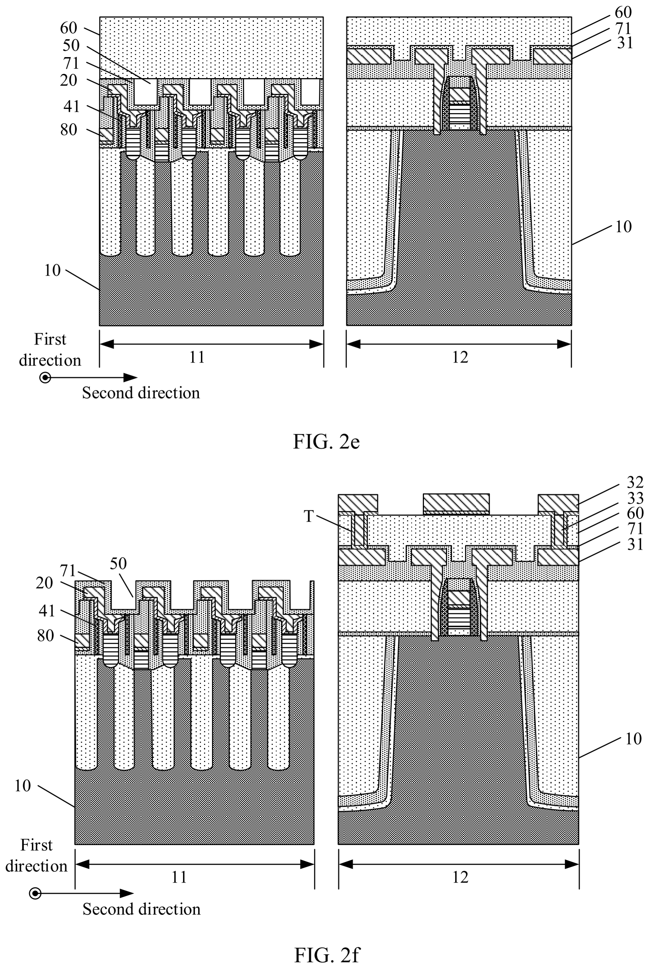

Next, referring to FIG. 2e, the step of 103 is performed, that is, the dielectric layer 60 is formed on the landing pad structures 20 and the first conductive layers 31, where the dielectric layer 60 covers the opening of the gap 50.

In an embodiment, the size of the first insulating layer 71 in a direction parallel to the thickness direction of the substrate 10 is smaller than the size of the dielectric layer 60 in the direction parallel to the thickness direction of the substrate 10.

In an actual operation, the dielectric layer 60 may be formed by a non-conformal deposition method. For example, the dielectric layer 60 is formed by adopting either of the physical vapor deposition process and the chemical vapor deposition process, or a combination thereof at a deposition speed of 200-1000 Å/min.

Specifically, the dielectric layer 60 is formed on the first insulating layer 71, and the bottom surface of the dielectric layer 60 is flush with or higher than the top surface of each of the landing pad structures 20.

It should be noted that the first insulating layer 71 may cover the sidewall of each of the landing pad structures 20. In this case, the bottom surface of the dielectric layer 60 is flush with the top surface of each of the landing pad structures 20. The first insulating layer 71 may alternatively cover the sidewall and the top surface of each of the landing pad structures 20. In this case, the bottom surface of the dielectric layer 60 is higher than the top surface of each of the landing pad structures 20. The bottom surface of the dielectric layer 60 is flush with or higher than the top surface of each of the landing pad structures 20, which indicates that the dielectric layer 60 is not filled or not completely filled in the gap 50, but covers the opening of the gap 50. In this way, the dielectric layer 60 can be quickly and conveniently removed subsequently, the sacrificial spacer layer 41 is exposed, and the sacrificial spacer layer 41 is further removed, to form air gaps 42. Therefore, a solution process is simpler, costs are reduced, and compatibility is high.

In an embodiment, the material of the dielectric layer 60 includes various materials. During deposition, these materials can be rapidly shaped without filling the gap 50 between the landing pad structures 20.

In some specific embodiments, a material layer of doped or undoped silicon oxide, such as undoped silicon glass (USG), undoped phosphor-silicon glass (PSG), undoped boron-phosphor-silicon glass (BPSG), boron-doped or phosphorus-doped spin-on-glass (Spin-On-Glass, SOG), phosphorus-doped tetraethyl orthosilicate (PTEOS), or boron-doped tetraethyl orthosilicate (BTEOS), formed by adopting a thermal chemical vapor deposition (Thermal CVD) fabrication process or a high-density plasma (HDP) fabrication process; a silicon oxide formed by a tetraethyl orthosilicate (TetraEthyl OrthoSilicate, TEOS); a silicon oxide formed by adopting a high aspect ratio process (High Aspect Ratio Process, HARP); or another suitable material may serve as the material of the dielectric layer 60.

Next, referring to FIG. 2f, the step of 104 is performed, that is, second conductive layers 32 are formed on the dielectric layer 60 in the peripheral region 12.

The material of each of the second conductive layers 32 includes but is not limited to tungsten (W), copper (Cu), titanium (Ti), tantalum (Ta), titanium nitride (TiN), tantalum nitride (TaN), a metal silicide, a metal alloy, or any combination thereof.

The foregoing method further includes the steps as follows. Before the second conductive layers 32 are formed, a trench T running through the dielectric layer 60 in the peripheral region 12 is formed, where the trench T exposes the surface of each of the first conductive layers 31; and
a conductive layer contact plug 33 is formed in the trench T; where the first conductive layers 31 are electrically connected to the second conductive layers 32 through the conductive layer contact plug 33. The conductive layer contact plug 33 may be formed in the same deposition step as the landing pad material layer 200 and the first conductive material layer 310.

Referring to FIG. 2f, the step of 105 is performed, that is, the dielectric layer 60 in the array region 11 is removed and the gap 50 is exposed.

Next, the step of 106 is performed, that is, the sacrificial spacer layer 41 is removed to form the air gaps 42.

In an embodiment, at least a part of the first insulating layer 71 is removed before the sacrificial spacer layer 41 is removed, to expose the top surface of the sacrificial spacer layer 41.

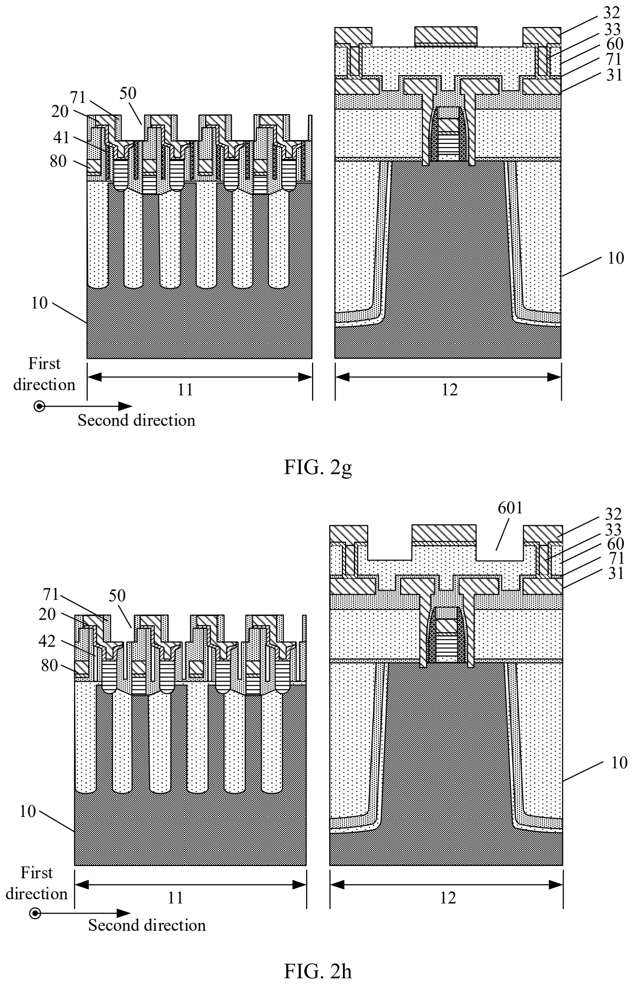

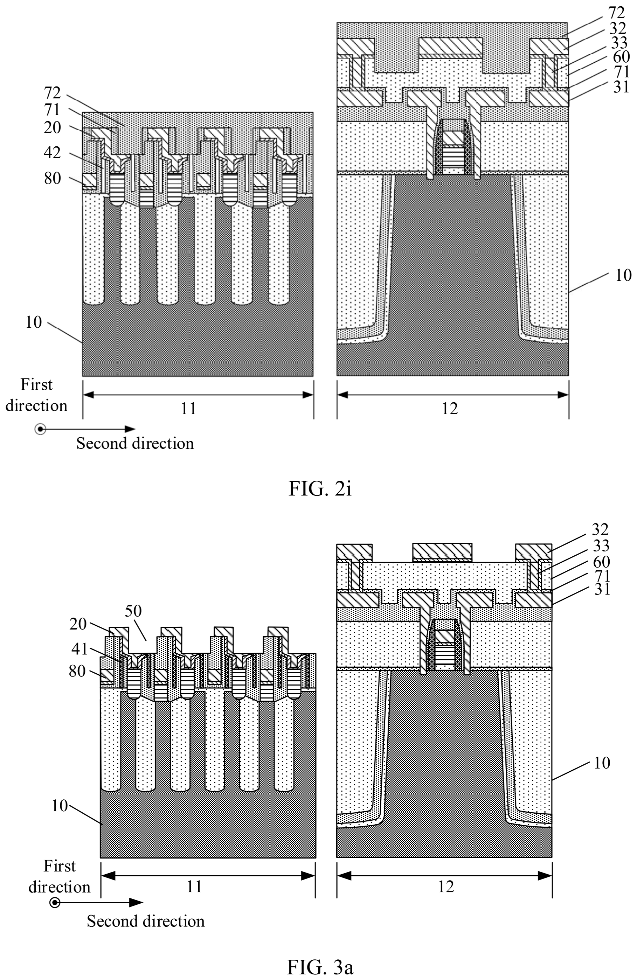

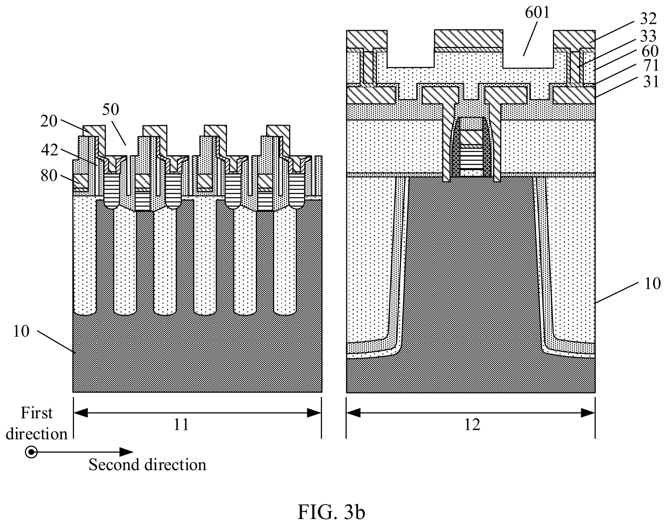

Specifically, FIG. 2g and FIG. 2h are schematic structural diagrams of a procedure of removing a first insulating layer 71 according to an embodiment of the present disclosure. FIG. 3a and FIG. 3b are schematic structural diagrams of a procedure of removing a first insulating layer 71 according to another embodiment of the present disclosure. The following first describes in detail the embodiment shown in FIG. 2g and FIG. 2h.

Referring first to FIG. 2g, that at least a part of the first insulating layer 71 is removed to expose the top surface of the sacrificial spacer layer 41 includes the step as follows.

The first insulating layer 71 covering the top surface of the sacrificial spacer layer 41 and the top surface of each of the landing pad structures 20 is removed by adopting a dry etching process, to expose the top surface of the sacrificial spacer layer 41.

In this embodiment, removing the first insulating layer 71 covering the top surface of the sacrificial spacer layer 41 can expose the top surface of the sacrificial spacer layer 41, so that the sacrificial spacer layer 41 is subsequently removed to form the air gaps 42. In addition, removing the first insulating layer 71 covering the top surface of each of the landing pad structures 20 can expose the landing pad structures 20, so that the capacitor structures 21 are subsequently formed on the landing pad structures 20 (refer to FIG. 4).

Next, referring to FIG. 2h, the sacrificial spacer layer 41 is removed to form the air gaps 42.

That the sacrificial spacer layer 41 is removed to form the air gaps 42 includes the step as follows. The sacrificial spacer layer 41 is removed by adopting a wet etching process to form the air gaps 42.

In some other embodiments, the sacrificial spacer layer 41 may alternatively be removed by adopting the dry etching process. Specifically, an etching process may be performed on the sacrificial spacer layer 41 by adopting an etching gas including gaseous hydrogen fluoride. The gaseous hydrogen fluoride has relatively good diffusion performance, which helps to fully remove the sacrificial spacer layer 41, thereby obtaining the air gaps 42 with a larger volume, and improving the effect of reducing the parasitic capacitance between the bit line structures 80 and the parasitic capacitance between each of the bit line structures 80 and the storage node contact plug 91.

Still referring to FIG. 2h, while the sacrificial spacer layer 41 is removed to form the air gaps 42, the second conductive layers 32 serve as masks. An isolation groove 601 is formed in the dielectric layer 60 in the peripheral region 12, the bottom surface of the isolation groove 601 is lower than the bottom surface of each of the second conductive layers 32, and the projection of the isolation groove 601 on the substrate 10 is located between the projections of the second conductive layers 32 on the substrate 10.

Subsequently, a material with a low dielectric constant may be formed in the isolation groove 601, to reduce the parasitic capacitance between the second conductive layers 32.

The following describes in detail the embodiment shown in FIG. 3a and FIG. 3b.

Referring first to FIG. 3a, the entire first insulating layer 71 located in the array region 11 is removed by adopting a wet etching process, to expose the top surface of the sacrificial spacer layer 41.

Specifically, the first insulating layer 71 may be removed by adopting a phosphoric acid (H₃PO₄) solution as an etching solution.

Next, referring to FIG. 3b, the sacrificial spacer layer 41 is removed to form the air gaps 42.

In this embodiment, a procedure of removing the sacrificial spacer layer 41 is the same as a procedure in the embodiment shown in FIG. 2h. Details are not described herein again.

Next, referring to FIG. 2i, the foregoing method further includes the steps as follows. A second insulating layer 72 is formed in the gap 50 between the two adjacent ones of the landing pad structures 20 after the air gaps 42 are formed, where the second insulating layer 72 covers an opening of each of the air gaps 42, the surface of each of the landing pad structures 20, fills the gap 50, and covers the surface of each of the second conductive layers 32, and the second insulating layer 72 may further fill the isolation groove 601. Further, the landing pad structures 20 may be exposed by removing the second insulating layer 72 covering the top surface of each of the landing pad structures 20, so that the capacitor structures 21 are subsequently formed on the landing pad structures 20 (refer to FIG. 4).

After the air gaps 42 are formed, the second insulating layer 72 is deposited to cover the air gaps 42, to ensure that the air gaps 42 are in a vacuum, thereby improving the effect of the air gaps 42 in reducing the parasitic capacitance.

It may be understood that in the embodiment shown in FIG. 3a and FIG. 3b, after the air gaps 42 are formed, the second insulating layer 72 may alternatively be formed at the opening of each of the air gaps 42.

In the embodiments of the present disclosure, the dielectric layer 60 is formed on the landing pad structures 20 and the first conductive layers 31, and the dielectric layer 60 covers the opening of the gap 50, but does not fill the gap 50. In this way, after the second conductive layers 32 are formed in the peripheral region 12, when the dielectric layer 60 in the array region 11 is removed, because the dielectric layer 60 does not fill the gap 50, there is no residue of the dielectric layer 60 removed in the gap 50, and there is no case in which formation of the air gaps 42 is affected by the residue. In addition, in the embodiments of the present disclosure, after the dielectric layer 60 is removed, the sacrificial spacer layer 41 can be simply and conveniently exposed, to remove the sacrificial spacer layer 41, and form the air gaps 42. Therefore, the solution provided in the embodiments of the present disclosure has simple processes, low costs, and air gaps 42 formed with a relatively good effect.

An embodiment of the present disclosure further provides a semiconductor structure. FIG. 4 is a schematic structural diagram of a semiconductor structure according to a semiconductor embodiment.

As shown in FIG. 4, the semiconductor structure includes: a substrate 10, including an array region 11 and a peripheral region 12; bit line structures 80 located on the array region 11, where the bit line structures 80 extend in a first direction; landing pad structures 20 arranged at intervals in the first direction and located between the bit line structures 80, where the first direction intersects a second direction and both are parallel to the surface of the substrate 10; air gaps 42, located between the landing pad structures 20 and the bit line structures 80; first conductive layers 31, located on the peripheral region 12; a first insulating layer 71, conformally covering the first conductive layers 31; a dielectric layer 60, located on the first insulating layer 71; and second conductive layers 32, located on the dielectric layer 60.

In an embodiment, the substrate 10 may be a silicon substrate, a germanium substrate, a silicon germanium substrate, a silicon carbide substrate, a silicon on insulator substrate, a germanium on insulator substrate, or the like, may be a substrate including another element semiconductor or a compound semiconductor, e.g., a glass substrate or a III-V group compound substrate (e.g., a gallium nitride substrate or a gallium arsenide substrate), may be a stacked structure, e.g., an Si/SiGe structure, or may be another epitaxial structure, e.g., a silicon germanium on insulator (SGOI) structure.

The substrate 10 includes an active region and an isolation region (not marked in FIG. 4), and the isolation region limits the substrate 10 to multiple discrete active regions.

A gate structure 13 is formed on the substrate 10 in the peripheral region 12. The gate structure 13 includes a gate insulating layer 131, a first gate conductive layer 132, a second gate conductive layer 133, a third gate conductive layer 134, and a cover layer 135 that are stacked sequentially from bottom to top. The material of the gate insulating layer 131 includes but is not limited to an oxide. The material of the first gate conductive layer 132 includes but is not limited to polysilicon. The material of the second gate conductive layer 133 includes but is not limited to titanium nitride. The material of the third gate conductive layer 134 includes but is not limited to metal tungsten. The material of the cover layer 135 includes but is not limited to an oxide, a nitride, a metal oxide, a nitrogen oxide, and the like.

In an embodiment, the semiconductor structure further includes a gate spacer layer 14, and the gate spacer layer 14 covers a sidewall of the gate structure 13.

The active region of the substrate 10 in the peripheral region 12 includes a first source drain region and a second source drain region (not marked in FIG. 4) located on two opposite sides of the gate structure 13.

The semiconductor structure further includes a connection column (not marked in FIG. 4), and the connection column electrically connects the first conductive layers 31 to the first source drain region and the second source drain region.

The first conductive layers 31 are located on the peripheral region 12. The material of each of the first conductive layers 31 includes but is not limited to tungsten (W), copper (Cu), titanium (Ti), tantalum (Ta), titanium nitride (TiN), tantalum nitride (TaN), a metal silicide, a metal alloy, or any combination thereof.

The first insulating layer 71 conformally covers the first conductive layers 31. The material of the first insulating layer 71 includes but is not limited to silicon nitride.

In some embodiments, as shown in FIG. 4, the first insulating layer 71 covers a part of the first conductive layers 31, and further covers a sidewall of each of the landing pad structures 20 in the array region 11.

In some other embodiments, the first insulating layer 71 includes a part covering the first conductive layers 31.

The dielectric layer 60 is located on the first insulating layer 71. In an embodiment, the material of the dielectric layer 60 includes at least one of the following: undoped silicon glass, phosphorus-doped silicon glass, boron-phosphorus-doped silicon glass, undoped spin-on-glass, boron-doped spin-on-glass, phosphorus-doped spin-on-glass. The dielectric layer 60 may be formed through deposition by utilizing undoped tetraethyl orthosilicate, phosphorus-doped tetraethyl orthosilicate, or boron-doped tetraethyl orthosilicate as a deposition source.

In an embodiment, the size of the first insulating layer 71 in a direction parallel to the thickness direction of the substrate 10 is smaller than the size of the dielectric layer 60 in the direction parallel to the thickness direction of the substrate 10.

The second conductive layers 32 are located on the dielectric layer 60. The material of each of the second conductive layers 32 includes but is not limited to tungsten (W), copper (Cu), titanium (Ti), tantalum (Ta), titanium nitride (TiN), tantalum nitride (TaN), a metal silicide, a metal alloy, or any combination thereof.

In an embodiment, the foregoing semiconductor structure further includes a conductive layer contact plug 33 running through the dielectric layer 60, where the first conductive layers 31 are electrically connected to the second conductive layers 32 through the conductive layer contact plug 33.

In an embodiment, an isolation groove 601 is formed in the dielectric layer 60, the bottom surface of the isolation groove 601 is lower than the bottom surface of each of the second conductive layers 32, and the projection of the isolation groove 601 on the substrate 10 is located between the projections of the second conductive layers 32 on the substrate 10.

In an embodiment, the isolation groove 601 is filled with a material with a low dielectric constant, and the material with the low dielectric constant can reduce the parasitic capacitance between the second conductive layers 32.

In an embodiment, as shown in FIG. 4, the semiconductor structure includes: the bit line structures 80 located on the array region 11, where the bit line structures 80 extend in the first direction, and the landing pad structures 20 arranged at intervals in the first direction and located between the bit line structures 80.

Each of the bit line structures 80 includes a first bit line conductive layer 81, a second bit line conductive layer 82, and a bit line cover layer 83 that are sequentially stacked. The material of the first bit line conductive layer 81 includes but is not limited to titanium nitride, tantalum nitride (TaN), metal silicide, metal alloy, or any combination thereof. The material of the second bit line conductive layer 82 includes but is not limited to tungsten (W), copper (Cu), titanium (Ti), or tantalum (Ta). The material of the bit line cover layer 83 includes but is not limited to silicon nitride. In a specific embodiment, the first bit line conductive layer 81 is a titanium nitride layer, and the second bit line conductive layer 82 is a metal tungsten layer.

The air gaps 42 are located among the landing pad structures 20 and the bit line structures 80.

In an embodiment, the foregoing semiconductor structure further includes: a storage node contact plug 91, where each of the landing pad structures 20 is located on the storage node contact plug 91, and capacitor structures 21 are located on the landing pad structures 20; and a bit line contact plug 92, where each of the bit line structures 80 is located on the bit line contact plug 92, and the air gaps 42 are at least partially located between the storage node contact plug 91 and each of the bit line structures 80.

The bit line structures 80 are electrically connected to the active region through the bit line contact plug 92. The material of the bit line contact plug 92 includes but is not limited to polysilicon.

Each of the air gaps 42 may be further located between each of the bit line structures 80 and the storage node contact plug 91, so that each of the air gaps 42 can better reduce the parasitic capacitance between each of the bit line structures 80 and the storage node contact plug 91.

The foregoing semiconductor structure further includes an isolation structure 15 (refer to FIG. 2b) that is alternately arranged with the storage node contact plug 91 in the first direction and that is located between the bit line structures 80. In addition, an isolation sidewall 101 is further formed on sidewalls of each of the bit line structures 80 on two sides in the second direction. The isolation structure 15 may separate the storage node contact plug 91 arranged in the first direction, and the isolation sidewall 101 may insulate the bit line structures 80 from the landing pad structures 20.

In an embodiment, the air gaps 42 are located on two sides of each of the bit line structures 80, and an extension direction of each of the air gaps 42 is the same as an extension direction of each of the bit line structures 80.

The foregoing semiconductor structure further includes a second insulating layer 72, and the second insulating layer 72 covers an opening of each of the air gaps 42, fills a gap 50, and is located between the second conductive layers 32. The second insulating layer 72 may be a low dielectric constant material, to reduce the parasitic capacitance between the landing pad structures 20 and the parasitic capacitance between the second conductive layers 32.

After the air gaps 42 are formed, the second insulating layer 72 is deposited to cover the air gaps 42, to ensure that the air gaps 42 are in a vacuum, thereby improving the effect of the air gaps 42 in reducing the parasitic capacitance.

The above is preferred embodiments of the present disclosure, and is not intended to limit the protection scope of the present disclosure. Any modification, equivalent replacement, improvement, and the like made within the spirit and principle of the present disclosure shall fall within the protection scope of the present disclosure.

### Industrial applicability

In the embodiments of the present disclosure, the dielectric layer is formed on the landing pad structures and the first conductive layers, and the dielectric layer covers the opening of the gap, but does not fill the gap. In this way, after the second conductive layers are formed in the peripheral region, when the dielectric layer in the array region is removed, because the dielectric layer does not fill the gap, there is no residue of the dielectric layer removed in the gap, and there is no case in which formation of the air gaps is affected by the residue. In addition, in the embodiments of the present disclosure, after the dielectric layer is removed, the sacrificial spacer layer can be simply and conveniently exposed, to remove the sacrificial spacer layer, and form the air gaps. Therefore, the solution provided in the embodiments of the present disclosure has simple processes, low costs, and air gaps formed with a relatively good effect.

## Claims

1. A fabrication method for a semiconductor structure, comprising:
providing a substrate (10), the substrate (10) comprising an array region (11) and a peripheral region (12);
forming, on the array region (11), a plurality of landing pad structures (20) arranged at intervals, forming first conductive layers (31) on the peripheral region (12), and forming a sacrificial spacer layer (41) on at least one side of each of the landing pad structures (20), a gap (50) existing between two adjacent ones of the landing pad structures (20);
forming a dielectric layer (60) on the landing pad structures (20) and the first conductive layers (31), the dielectric layer (60) covering an opening of the gap (50);
forming second conductive layers (32) on the dielectric layer (60) in the peripheral region (12);
removing the dielectric layer (60) in the array region (11) and exposing the gap (50); and
removing the sacrificial spacer layer (41) to form air gaps (42).

2. The method according to claim 1, wherein a material of the dielectric layer (60) comprises at least one of the following: undoped silicon glass, phosphorus-doped silicon glass, boron-phosphorus-doped silicon glass, undoped spin-on-glass, boron-doped spin-on-glass, and phosphorus-doped spin-on-glass.

3. The method according to claim 1 or 2, further comprising:
forming, before the dielectric layer (60) is formed, a first insulating layer (71) covering a surface of each of the landing pad structures (20), a top surface of the sacrificial spacer layer (41), and the first conductive layers (31), wherein a thickness of the first insulating layer (71) is less than one half of a minimum inner diameter of the gap (50);
forming the dielectric layer (60) on the first insulating layer (71), wherein a bottom surface of the dielectric layer (60) is flush with or higher than a top surface of each of the landing pad structures (20); and
removing at least a part of the first insulating layer (71) before the sacrificial spacer layer (41) is removed, to expose the top surface of the sacrificial spacer layer (41).

4. The method according to claim 3, wherein the removing at least a part of the first insulating layer (71) to expose the top surface of the sacrificial spacer layer (41) comprises:
removing, by adopting a dry etching process, the first insulating layer (71) covering the top surface of the sacrificial spacer layer (41) and the top surface of each of the landing pad structures (20), to expose the top surface of the sacrificial spacer layer (41);
or
removing, by adopting a wet etching process, the entire first insulating layer (71) located in the array region (11), to expose the top surface of the sacrificial spacer layer (41).

5. The method according to any one of claims 1 to 4, wherein the removing the sacrificial spacer layer (41) to form air gaps (42) comprises: removing the sacrificial spacer layer (41) by adopting the wet etching process to form the air gaps (42).

6. The method according to any one of claims 1 to 5, further comprising:
forming a second insulating layer (72) in the gap (50) between the two adjacent ones of the landing pad structures (20) after the air gaps (42) are formed, wherein the second insulating layer (72) covers an opening of each of the air gaps (42).

7. The method according to any one of claims 1 to 6, wherein before the plurality of landing pad structures (20) arranged at intervals are formed on the array region (11), the method further comprises:
forming a plurality of bit line structures (80) on the array region (11), wherein the bit line structures (80) extend in a first direction, and the sacrificial spacer layer (41) is formed on a sidewall of each of the bit line structures (80);
forming a contact hole (901) and an isolation structure (15) alternately arranged in the first direction between the bit line structures (80), wherein the contact hole (901) exposes the substrate (10), and the first direction is parallel to a surface of the substrate (10); and
forming a storage node contact plug (91) in the contact hole (901), wherein each of the landing pad structures (20) is located on the storage node contact plug (91).

8. The method according to claim 7, wherein the forming, on the array region (11), a plurality of landing pad structures (20) arranged at intervals comprises:
forming a landing pad material layer (200) on the storage node contact plug (91), wherein a top surface of the landing pad material layer (200) is higher than a top surface of each of the bit line structures (80); and
etching back a part of the landing pad material layer (200) and parts of the bit line structures (80) to form the landing pad structures (20) and the gap (50) located on one side of each of the landing pad structures (20), wherein a projection of each of the landing pad structures (20) on the substrate (10) partly overlaps a projection of each of the bit line structures (80) on the substrate (10).

9. The method according to any one of claims 1 to 8, further comprising:
forming, before the second conductive layers (32) are formed, a trench (T) running through the dielectric layer (60) in the peripheral region (12), wherein the trench (T) exposes a surface of each of the first conductive layers (31); and
forming a conductive layer contact plug (33) in the trench (T), wherein the first conductive layers (31) are electrically connected to the second conductive layers (32) through the conductive layer contact plug (33).

10. A semiconductor structure, comprising:
a substrate (10), comprising an array region (11) and a peripheral region (12);
bit line structures (80) located on the array region (11), the bit line structures (80) extending in a first direction;
landing pad structures (20) arranged at intervals in the first direction and located between the bit line structures (80); the first direction being parallel to a surface of the substrate (10);
air gaps (42), located among the landing pad structures (20) and the bit line structures (80);
first conductive layers (31), located on the peripheral region (12);
a first insulating layer (71), conformally covering the first conductive layers (31);
a dielectric layer (60), located on the first insulating layer (71); and
second conductive layers (32), located on the dielectric layer (60).

11. The semiconductor structure according to claim 10, wherein a material of the dielectric layer (60) comprises at least one of the following:
undoped silicon glass, phosphorus-doped silicon glass, boron-phosphorus-doped silicon glass, undoped spin-on-glass, boron-doped spin-on-glass, phosphorus-doped spin-on-glass, undoped tetraethyl orthosilicate, phosphorus-doped tetraethyl orthosilicate, or boron-doped tetraethyl orthosilicate.

12. The semiconductor structure according to claim 10 or 11, wherein
a size of the first insulating layer (71) in a direction parallel to a thickness direction of the substrate (10) is smaller than a size of the dielectric layer (60) in the direction parallel to the thickness direction of the substrate (10).

13. The semiconductor structure according to any one of claims 10 to 12, wherein
the air gaps (42) are located on two sides of each of the bit line structures (80), and an extension direction of each of the air gaps (42) is the same as an extension direction of each of the bit line structures (80).

14. The semiconductor structure according to any one of claims 10 to 13, wherein the semiconductor structure further comprises:
a storage node contact plug (91), wherein each of the landing pad structures (20) is located on the storage node contact plug (91); and
a bit line contact plug (92), wherein each of the bit line structures (80) is located on the bit line contact plug (92); and
the air gaps (42) are at least partially located between the storage node contact plug (91) and each of the bit line structures (80).

15. The semiconductor structure according to any one of claims 10 to 14, wherein an isolation groove (601) is formed in the dielectric layer (60), a bottom surface of the isolation groove (601) is lower than a bottom surface of each of the second conductive layers (32), and a projection of the isolation groove (601) on the substrate (10) is located between projections of the second conductive layers (32) on the substrate (10).

16. The semiconductor structure according to claim 14, wherein the semiconductor structure further comprises capacitor structures (21), and the capacitor structures (21) are located on the landing pad structures (20).

17. The semiconductor structure according to any one of claims 10 to 14, wherein the semiconductor structure further comprises a second insulating layer (72), and the second insulating layer (72) covers an opening of each of the air gaps (42) and is located between the second conductive layers (32).

18. The semiconductor structure according to claim 17, wherein the second insulating layer (72) comprises a low dielectric constant material.
